(19) Europäisches Patentamt
European Patent Office
Office européen des brevets

(11) **EP 2 685 493 A2**

(12) **EUROPEAN PATENT APPLICATION**

(43) Date of publication:
**15.01.2014 Bulletin 2014/03**

(51) Int Cl.:
**H01L 23/467** (2006.01)

(21) Application number: **12191747.0**

(22) Date of filing: **08.11.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **10.07.2012 KR 20120075121**

(71) Applicant: **Samsung Electro-Mechanics Co., Ltd Suwon**
**Gyunggi-do 443-743 (KR)**

(72) Inventors:
• **Hong, Chang Seob**
**443-743, Yeongtong-gu, Suwon, Gyunggi-do (KR)**
• **Kwak, Young Hoon**
**443-743 Yeongtong-gu, Suwon, Gyunggi-do (KR)**
• **Sohn, Young Ho**
**443-743, Yeongtong-gu, Suwon, Gyunggi-do (KR)**

(74) Representative: **Heine, Christian Klaus**
**KNH Patentanwälte**
**Kahlhöfer Neumann Rößler Heine**
**Postfach 10 33 63**
**40024 Düsseldorf (DE)**

(54) **Multi-stage heat sink, cooling system with the same and method for controlling the same**

(57) Disclosed herein is a multi-stage heat sink cooling system, including: at least one step surface in a direction of a surface to which cooling air is injected, wherein the step surface is any one of a step surface having a stair shape that is provided with a plurality of heat radiating plates each having a curve, a step surface provided with a plurality of heat radiating plates having a streamlined smooth curve, and a step surface provided with a plurality of heat radiating fins having a height difference. According to the preferred embodiments of the present invention, the cooling system with the multi-stage heat sink can cool heat generated from a heat radiating element using the multi-stage heat sink and the air injection part to improve a heat release rate.

FIG.1

## Description

CROSS REFERENCE TO RELATED APPLICATION

This application claims the benefit of Korean Patent Application No. 10-2012-0075121, filed on July 10, 2012, entitled "Multi-Stage Heat Sink, Cooling System With the Same and Method for Controlling the Same", which is hereby incorporated by reference in its entirety into this application.

BACKGROUND OF THE INVENTION

1. Technical Field

The present invention relates to a multi-stage heat sink, a cooling system with the same, and a method for controlling the same.

2. Description of the Related Art

Optical communication components and electric and electronic components are miniaturized by a semiconductor device and therefore, absolutely needed to be cooled and maintained at a constant temperature due to noise, lifespan reduction, and instability of output characteristics that are caused by heat involved in the miniaturization. For example, as a demand for a high-performance and high-speed PC is increased, the integration of PC is gradually increased. However, a technology for effectively radiating and cooling heat generated according to the increase in heat generation involved in the high integration has not yet been developed.
Meanwhile, as electronic devices are miniaturized with the high integration of an electronic chip, there is a need to solve a complex thermal problem in electronic components or systems. The problem of removing heat generated according to the high integration of the electronic chip is gradually important, but is very various and complicated according to a size and a shape, a heating value, and internal thermal resistance of a chip.
Consequently, lifespan or reliability of the electronic chip largely depends on an operating temperature of the chip. In particular, it has been known that the lifespan of the electronic chip is reduced by 50% or more whenever the operating temperature thereof is higher by 10 °C than a design temperature.
Therefore, various cooling technologies capable of removing high heat flux while maintaining the electronic chip at low temperature need to be developed so as to improve the lifespan and development ofthe electronic devices.
Generally, as described in Korean Patent Laid-Open Publication No. 2002-0048844 (Laid-Open Publication Date: June 24, 2002), the heat sink basically uses a rectangular straight fin (RSF) type in which vertical heat radiating fins each are a plate shape but prevalently uses a splitted rectangular straight fin (SRSF), a pin fin (PF) type, and the like. Further, Korean Patent Laid-Open Publication No. 2002-0048844 discloses a porous type as a structure for increasing a heat release rate per a unit area.
The heat sink of the prior art uses a type of heat-conducting from a heat generation source to a heat radiating plate that is a bottom surface of the heat sink, from the bottom surface of the heat sink to the heat radiating fin, and again contacting the heat radiating fin to air to cool heat.
Most ofthe heat sinks used in the prior art have been used as an extrusion type, but have restrictively been used as a problem of a heat release rate. As the method for solving the problem, there are no special alternatives but to increase the heat sink.
That is, since a temperature difference between an end of the horizontal heat radiating plates and an end of the vertical heat radiating fins that configure the heat sink of the prior art is increased, a heat transfer quantity may be relatively reduced and the heat sink has a limited heat release rate so much.

SUMMARY OF THE INVENTION

The present invention has been made in an effort to provide a multi-stage heat sink of a structure having a plurality of steps.
Further, the present invention has been made in an effort to provide a cooling system with a multi-stage heat sink of a structure having a plurality of steps.
In addition, the present invention has been made in an effort to provide a method for controlling cooling using a cooling system with a multi-stage heat sink of a structure having a plurality of steps.
According to a preferred embodiment of the present invention, there is provided a multi-stage heat sink formed to have at least one step surface in a direction of a surface to which cooling air is injected.
The step surface may be a step surface having a stair shape that is provided with a plurality of heat radiating plates each having a curve.
The step surface may be provided with the plurality of heat radiating plates having a streamlined smooth curve.
The step surface may be provided with a plurality of heat radiating fins having a height difference.
According to another preferred embodiment of the present invention, there is provided a cooling system, including: a multi-stage heat sink including a surface having at least one step; an air injection part coupled with step surfaces ofthe multi-stage heat sink and supplying cooling air; and a control unit connected to the multi-stage heat sink to control cooling using the multi-stage heat sink and the air injection part.
The multi-stage heat sink may be provided with a plate-shaped member of which the heat radiating plates each have a curve so as to be formed to have the step surfaces in a direction of a surface to which the cooling air is injected.

The multi-stage heat sink may be provided with a plurality of heat radiating plates having a streamlined smooth curve so as to be formed to have the step surfaces in a direction of a surface to which the cooling air is injected.

The multi-stage heat sink may be formed to have a plurality of heat radiating fins having a height difference so as to be formed to have the step surfaces in a direction of a surface to which the cooling air is injected.

The cooling system may further include: a temperature sensor provided at one portion of the multi-stage heat sink, wherein temperature information of the multi-stage heat sink detected by the temperature sensor is transferred to the control unit.

The air injection part may be separately provided with a plurality of injection holes from a bottom portion thereof and inject the cooling air to each step surface of the multi-stage heat sink through the injection holes from an air pump connected to the control unit.

The control unit may control airflow rate, initial temperature, and flow velocity of the cooling air through the air pump.

The multi-stage heat sink may be mounted at one portion of a heat radiation object via a heat conductive paste.

According to another preferred embodiment of the present invention, there is provided a method for controlling cooling, including: starting a cooling process by controlling an air pump by a control unit so as to inject cooling air to a multi-stage heat sink through an air injection part; determining, by the control unit, whether temperature of the multi-stage heat sink or the cooling air is higher than set cooling reference temperature; correcting, by the control unit, cooling conditions if it is determined that the temperature of the multi-stage heat sink or the cooling air is higher than the set cooling reference temperature; and performing, by the control unit, cooling using the multi-stage heat sink and the cooling air according to the corrected cooling conditions.

In the starting of the cooling process, the air injection part may include a plurality of injection holes along steps of the multi-stage heat sink and each of the injection holes may be engaged with step surfaces of the multi-stage heat sink.

In the starting of the cooling process, the control unit may receive temperature information of the multi-stage heat sink detected by a temperature sensor mounted at one portion of the multi-stage heat sink in real time.

In the correcting of the cooling conditions, the cooling conditions may include airflow rate, initial temperature, and flow velocity of the cooling air.

BRIEF DESCRIPTION OF THE DRAWINGS

The above and other objects, features and advantages of the present invention will be more clearly understood from the following detailed description taken in conjunction with the accompanying drawings, in which:

FIG. 1 is a configuration diagram for describing a cooling system with a multi-stage heat sink according to a first preferred embodiment of the present invention;
FIG. 2A is a perspective view of a multi-stage heat sink according to a second preferred embodiment of the present invention;
FIG. 2B is a perspective view of a multi-stage heat sink according to a third preferred embodiment of the present invention;
FIG. 3 is a side cross-sectional view of the multi-stage heat sink according to the first preferred embodiment of the present invention;
FIG. 4 is a perspective view of a case in which the multi-stage heat sink according to the first preferred embodiment of the present invention is applied to a power semiconductor module;
FIG. 5 is a flow chart for describing a method for controlling cooling in a cooling system with a multi-stage heat sink according to another preferred embodiment of the present invention;
FIG. 6 is a cooling graph detected in the cooling system with the multi-stage heat sink according to the first embodiment of the present invention and the cooling system with the heat sink according to the prior art, respectively; and
FIG. 7 is a simulation diagram for describing heat radiating characteristics of the multi-stage heat sink according to the first embodiment of the present invention.

DESCRIPTION OF THE PREFERRED EMBODIMENTS

The objects, features and advantages of the present invention will be more clearly understood from the following detailed description of the preferred embodiments taken in conjunction with the accompanying drawings. Throughout the accompanying drawings, the same reference numerals are used to designate the same or similar components, and redundant descriptions thereof are omitted. Further, in the following description, the terms "first", "second", "one side", "the other side" and the like are used to differentiate a certain component from other components, but the configuration of such components should not be construed to be limited by the terms. Further, in the description of the present invention, when it is determined that the detailed description of the related art would obscure the gist of the present invention, the description thereof will be omitted.

Hereinafter, preferred embodiments of the present invention will be described in detail with reference to the attached drawings.

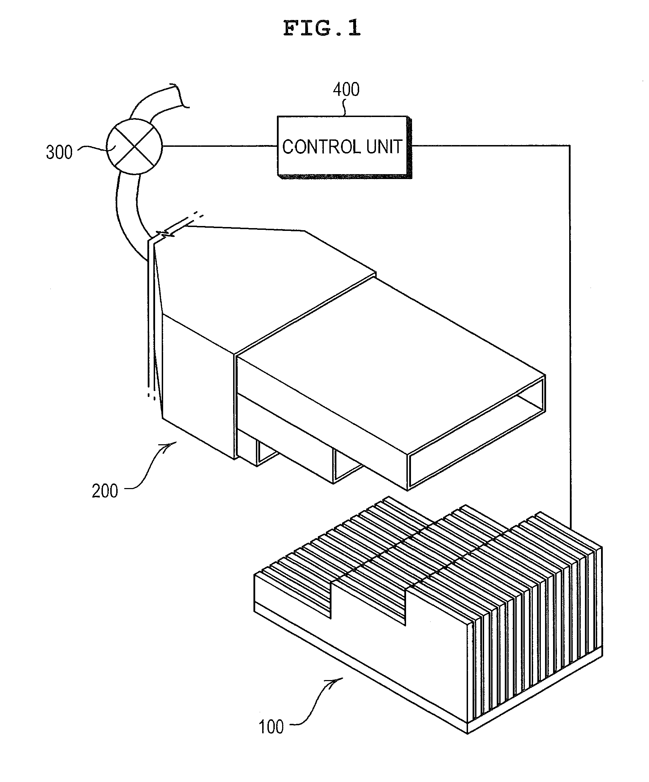

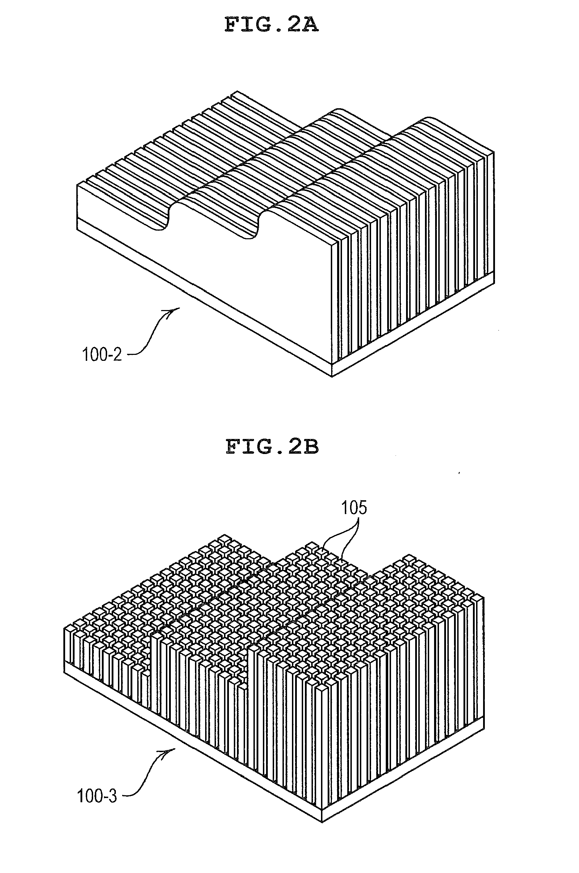

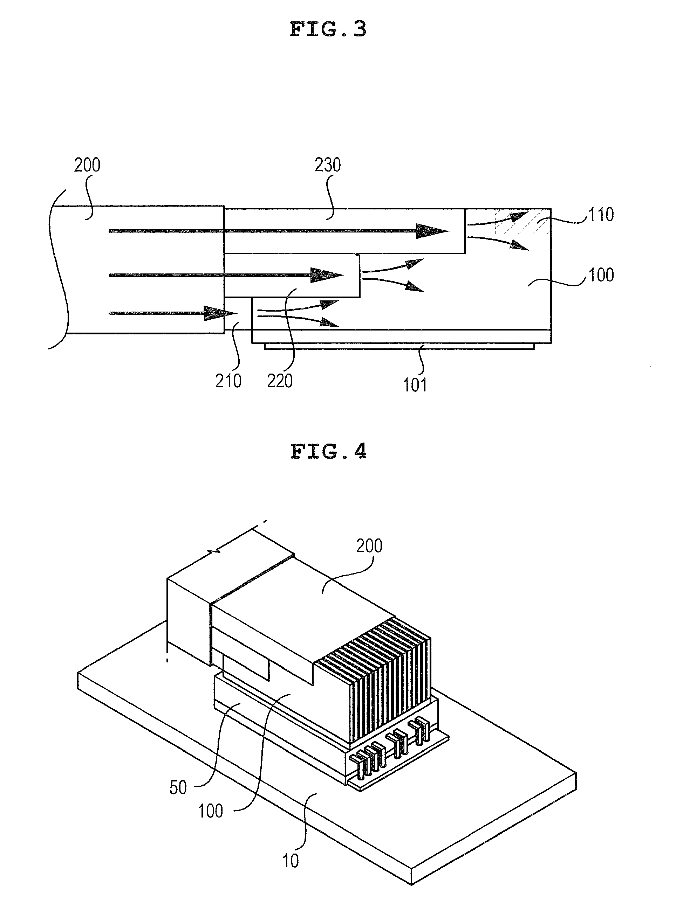

FIG. 1 is a configuration diagram for describing a cooling system with a multi-stage heat sink according to a first preferred embodiment of the present invention, FIG. 2A is a perspective view of a multi-stage heat sink according to a second preferred embodiment of the present invention, FIG. 2B is a perspective view of a multi-stage heat sink according to a third preferred embodiment of the present invention, and FIG. 3 is a side cross-sectional view of an example in which the multi-stage heat sink according to the preferred embodiment of the present invention is applied to a power semiconductor module.

As shown in FIG. 1, a cooling system with a multi-stage heat sink according to a preferred embodiment of the present invention includes a multi-stage heat sink 100 with a plurality of steps, an air injection unit 200 coupled with a step surface of the multi-stage heat sink 100 and supplying cooling air to the multi-stage heat sink 110 through an air pump 300, and a control unit 400 generally controlling a cooling process using the multi-stage heat sink 100.

The multi-stage heat sink 100 are mounted at one portion of heat radiation objects such as a power semiconductor module, and the like, through a heat conductive paste 101, wherein a plated-shaped member of which the plurality of heat radiating plates having a stair shape with at least three steps each have a curve is mounted in a direction of a surface to which the cooling air is injected, and the air injection part 200 is coupled with a step surface configured of the plurality of heat radiating plates on which the steps are formed.

As shown in FIG. 3, in the multi-stage heat sink 100, a temperature sensor 110 may be provided at one portion of a surface through which the injected air is discharged, wherein the surface is opposite to the step surface and temperature information detected by the temperature sensor 110 may be transferred to the control unit 400.

In addition, in addition to the multi-stage heat sink 100 shown in a stair shape of FIG. 1, a multi-stage heat sink 100-2 according to a second embodiment of the present invention in which a plurality of heat radiating plates having a streamlined smooth curve are formed as shown in FIG. 2A or a multi-stage heat sink 100-3 according to a third embodiment of the present invention in which a plurality of heat radiating fins 105 have a height difference and a step surface is formed as shown in FIG. 2B may be selectively used.

The multi-stage heat sink 100-2 according to the second embodiment of the present invention shown in FIG. 2A may easily perform heat exchange by smoothly injecting air into the step surface having the streamlined smooth curve and the multi-stage heat sink 100-3 according to the third embodiment of the present invention shown in FIG. 2B may increase efficiency of heat exchange by increasing a heat radiating area contacting air injected by the plurality of heat radiating fins 105.

The air injection part 200 is a member that is engaged with the step surface of the multi-stage heat sink 100 and injects the cooling air supplied from the air pump 300 to each step surface of the heat sink 100 through, for example, a first injection hole 210, a second injection hole 220, and a third injection hole 230. The air injection part 200 may inject the cooling air to each step surface of the heat sink 100 while maintaining an initial temperature of the cooling air using the first injection hole 210, the second injection hole 220, and the third injection hole 230.

In detail, as shown in FIG. 3, the cooling air injected through the first injection hole 210 first performs heat exchange at a bottom portion of the multi-stage heat sink 100.

Thereafter, the cooling air with the temperature increased through the bottom portion of the multi-stage heat sink 100 has the reduced temperature by being coupled with the cooling air injected through the second injection hole 220 and performs heat exchange at a middle step portion of the multi-stage heat sink 100, together with the cooling air injected through the second injection hole 220.

Next, the cooling air with the temperature increased through the middle step portion of the multi-stage heat sink 100 has the reduced temperature again by being coupled with the cooling air injected through the third injection hole 230 and may perform heat exchange at a top portion of the multi-stage heat sink 100, together with the cooling air injected through the third injection hole 230.

Further, the air injection part 200 may include at least three injection holes according to the step of the multi-stage heat sink 100 so as to more improve the cooling efficiency.

The control unit 400 is a portion that is connected to the temperature sensor 110 of the multi-stage heat sink 100, the air pump 300, and the like, to generally control the cooling process using the multi-stage heat sink 100 and may control an airflow rate, initial temperature, flow velocity, and the like, of the cooling air injected through the air pump 300 from the air injection part 200 according to the temperature information transferred from the temperature sensor 110.

In the cooling system according to the preferred embodiment of the present invention configured as described above, as shown in FIG.4, the power semiconductor module including a power semiconductor device 50 mounted on the substrate 10 may be used and the multi-stage heat sink 100 according to the preferred embodiment of the present invention is mounted on the top surface of the power semiconductor device 50, thereby injecting the cooling air through the air injection part 200.

Therefore, the cooling system according to the preferred embodiment of the present invention may improve the heat release rate using the multi-stage heat sink 100 and the air injection part 200 so as to reduce the heat generated from the power semiconductor device 50.

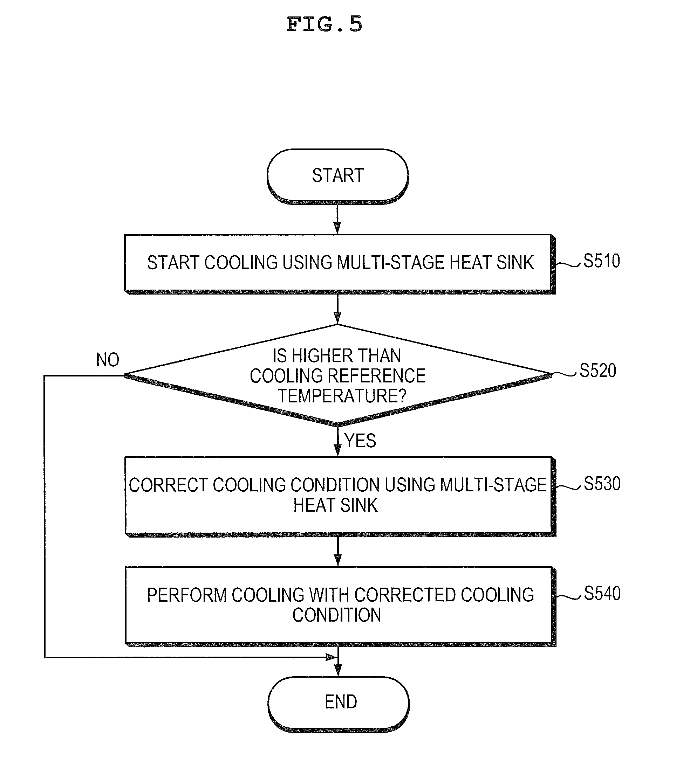

Hereinafter, a method for controlling cooling using a multi-stage heat sink according to another preferred embodiment of the present invention will be described with reference to FIG. 5. FIG. 5 is a flow chart for describing a method for controlling cooling in a cooling system with a multi-stage heat sink according to another preferred embodiment ofthe present invention.

In the method for controlling cooling using a multi-stage heat sink according to another preferred embodiment of the present invention, the control unit 400 controls the air pump 300 to start the cooling by injecting the cooling air through the air injection part 200 in the state in which the multi-stage heat sink 100 is mounted in the object to be cooled (S510).

Here, the object to be cooled may include a package or a device that is essentially subjected to cooling so as to radiate heat such as an LED, PC, and the like, in addition to the power semiconductor device 50 shown in FIG. 4.

The control unit 400 receives the temperature information including the temperature of air or the multi-stage heat sink 100 in real time from the temperature sensor 110 provided at one side of the multi-stage heat sink 100 while injecting the cooling air through the air injection part 200.

The control unit 400 determines whether the temperature of the cooling air or the multi-stage heat sink 100 included in the temperature information is higher than the set cooling reference temperature according to the reception ofthe temperature information (S520).

That is, as 20 °C above zero that is, for example, a room temperature is set as a cooling reference temperature during the cooling process using the multi-stage heat sink 100 and the air injection part 200, the control unit 400 may be determined whether the temperature ofthe cooling air or the multi-heat sink 100 received in real time from the temperature sensor 110 is detected as temperature higher than the cooling reference temperature that is 20 °C above zero.

When the temperature ofthe cooling air or the multi-stage heat sink 100 is detected as the temperature higher than the cooling reference temperature by the determination, the control unit 400 corrects the cooling conditions using the multi-stage heat sink 100 and the air injection part 200(S530).

In detail, in order to reduce the temperature ofthe cooling air or the multi-stage heat sink 100 that is detected as the temperature higher than the cooling reference temperature to the cooling reference temperature or less, the control unit 400 may correct the cooling conditions using the multi-stage heat sink 100 and the air injection part 200, for example, the airflow rate, the initial temperature, the flow velocity, and the like, ofthe cooling air.

In particular, the control unit 400 may adjust the airflow rate of the cooling air transferred to the air injection part 200 through the air pump 300 to easily reduce the temperature ofthe multi-stage heat sink 100 to the cooling reference temperature or less.

That is, it can appreciate the correlation between the airflow rate of the cooling air injected through the air injection part 200 and the temperature of the multi-stage heat sink 100 by Equation 1 regarding the relationship between the amount of heat radiation (Q) and the airflow rate (W).

[Equation 1]

$$Q = WCdt$$

(Q = the amount of heat radiation, W = airflow rate of cooling air (Kg/h), C = specific heat of air (0.24 Kcal/Kg), dt = temperature difference between cooling air and object to be cooled)

Clearly representing the correlation between the airflow rate of the cooling air and the temperature of the multi-stage heat sink 110 by modifying the above [Equation 1], it may be represented by the following [Equation 2].

[Equation 2]

$$W = \frac{Q}{Cdt}$$

As in the relationship Equation, the airflow rate W of the cooling air and the amount of heat radiation Q of the multi-stage heat sink 100 has a proportional relation. According to the above characteristic, the control unit 400 may increase the airflow rate of the cooling air injected through the air injection part 200 to reduce the temperature of the multi-stage heat sink 100 to the cooling reference temperature or less.

After the cooling conditions are corrected, the control unit 400 performs cooling us ing the multi-stage heat sink 100 and the air injection part 200 according to the corrected cooling conditions (S540).

The cooling system performs the cooling through the cooling process, which is represented by a cooling graph as "I" shown in FIG. 5.

In detail, as the flow of the cooling air is injected through the first injection hole 210 at high speed in period A, the heat exchange is performed at the bottom portion of the multi-stage heat sink 100 and the cooling air has the initial cooling temperature and is directly injected to the middle step portion of the multi-stage heat sink 100 through the second injection hole 220 in period B so that the cooling air is in contact with the middle step portion of the multi-stage heat sink 100, thereby maximizing the cooling effect.

In this case, a part of the cooling air injected through the second injection hole 220 is mixed with air with increased temperature while passing through the period A, thereby reducing the temperature of air passing through the period A.

Next, similarly to the cooling air injected through the third injection hole 230 in period C, the cooling air has the initial cooling temperature and performs heat exchange at the top portion of the multi-stage heat sink 100.

As such, each injection hole from the first injection hole 210 to the third injection hole 230 are separated from each other and therefore, the cooling airs are not mixed with each other before the cooling air is injected to each step surface of the multi-stage heat sink 100.

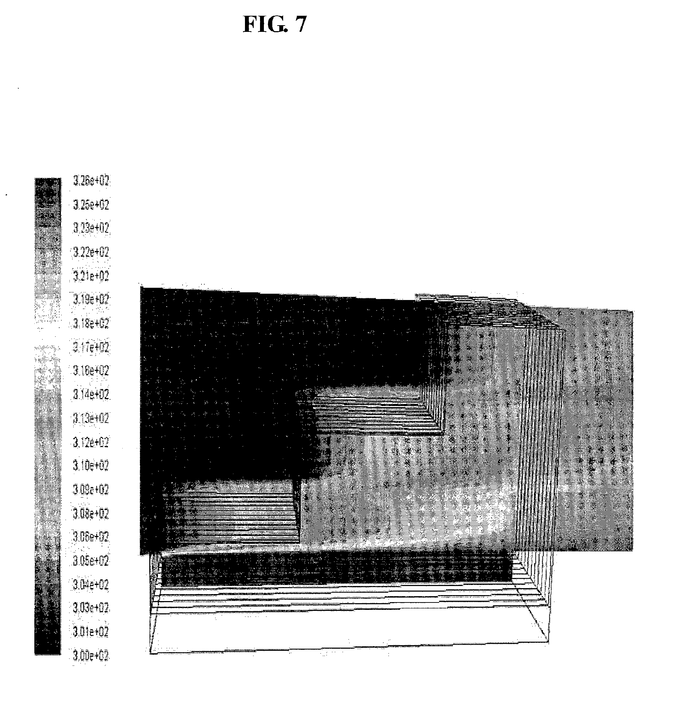

The results meet simulation results shown in FIG. 7. Therefore, the heat exchange may be sequentially performed at each step of the multi-stage heat sink 100 by the air injected through each injection hole 210, 220, and 230, thereby improving the cooling efficiency using the multi-stage heat sink 100.

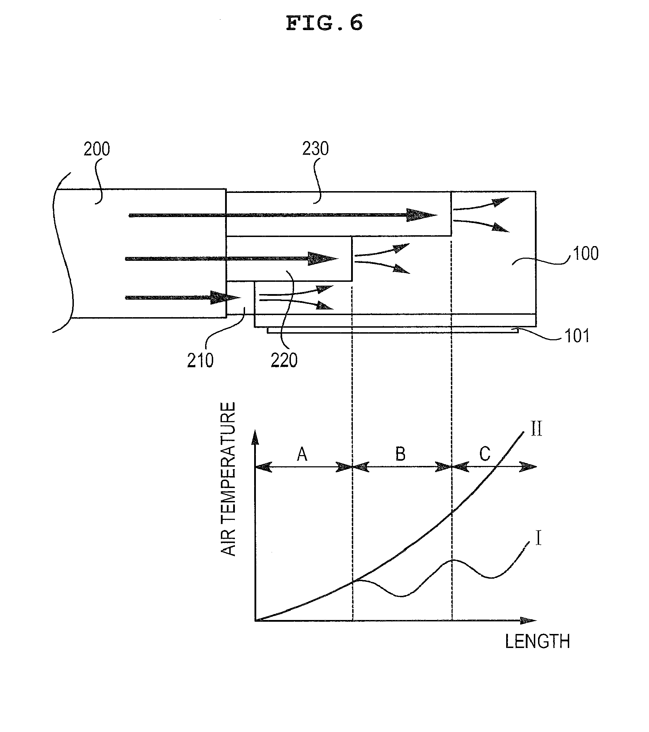

On the other hand, a graph of "II" shown in FIG. 6, which is a cooling graph in the case in which the heat sink according to the prior art without steps is applied, is a graph showing the detected temperature of the cooling air discharged after air is injected to the heat sink in the rectangular straight fin (RSF) type in which each of the heat radiating plates has a plate shap e due to the absence of steps.

As shown in FIG. 6, when comparing the cooling graph of "II" in which the heat sink according to the prior art without steps is applied with the cooling graph of "I" using the multi-stage heat sink 100 according to the embodiment of the present invention, it can be appreciated that the temperature of air discharged from the heat sink according to the prior art is detected higher than the temperature of air discharged from the multi-stage heat sink 100 according to the embodiment of the present invention.

Therefore, it can be appreciated that the cooling efficiency using the multi-stage heat sink 100 according to the embodiment of the present invention is more excellent than the cooling efficiency using the heat sink according to the prior art.

According to the preferred embodiments of the present invention, the cooling system with the multi-stage heat sink can cool heat generated from the heat radiating element using the multi-stage heat sink and the air injection part to improve the heat release rate.

In addition, the method for controlling cooling using the multi-stage heat sink according to the preferred embodiments of the present invention can improve the cooling efficiency using the multi-stage heat sink and the air injection part.

Although the embodiments of the present invention have been disclosed for illustrative purposes, it will be appreciated that the present invention is not limited thereto, and those skilled in the art will appreciate that various modifications, additions and substitutions are possible, without departing from the scope and spirit of the invention.

Accordingly, any and all modifications, variations or equivalent arrangements should be considered to be within the scope of the invention, and the detailed scope of the invention will be disclosed by the accompanying claims.

**Claims**

1. A multi-stage heat sink formed to have at least one step surface in a direction of a surface to which cooling air is injected.

2. The multi-stage heat sink as set forth in claim 1, wherein the step surface is a step surface having a stair shape that is provided with a plurality of heat radiating plates each having a curve.

3. The multi-stage heat sink as set forth in claim 1, wherein the step surface is provided with the plurality of heat radiating plates having a streamlined smooth curve.

4. The multi-stage heat sink as set forth in claim 1, wherein the step surface is provided with a plurality of heat radiating fins having a height difference.

5. A cooling system, comprising:

   a multi-stage heat sink including a surface having at least one step;
   an air injection part coupled with step surfaces of the multi-stage heat sink and supplying cooling air; and
   a control unit connected to the multi-stage heat sink to control cooling using the multi-stage heat sink and the air injection part.

6. The cooling system as set forth in claim 5, wherein the multi-stage heat sink is provided with a plate-shaped member of which each heat radiating plate has a curve so as to be formed to have the step surfaces in a direction of a surface to which the cooling air is injected.

7. The cooling system as set forth in claim 5, wherein the multi-stage heat sink is provided with a plurality of heat radiating plates having a streamlined smooth curve so as to be formed to have the step surfaces in a direction of a surface to which the cooling air is injected.

8. The cooling system as set forth in claim 5, wherein the multi-stage heat sink is formed to have a plurality of heat radiating fins having a height difference so as to be formed to have the step surfaces in a direction of a surface to which the cooling air is injected.

9. The cooling system as set forth in claim 5, further comprising:

a temperature sensor provided at one portion of the multi-stage heat sink,

wherein temperature information of the multi-stage heat sink detected by the temperature sensor is transferred to the control unit.

10. The cooling system as set forth in claim 5, wherein the air injection part is separately provided with a plurality of injection holes from a bottom portion thereof and injects the cooling air to each step surface of the multi-stage heat sink through the injection holes from an air pump connected to the control unit.

11. The cooling system as set forth in claim 10, wherein the control unit controls airflow rate, initial temperature, and flow velocity of the cooling air through the air pump.

12. The cooling system as set forth in claim 5, wherein the multi-stage heat sink is mounted at one portion of a heat radiation object via a heat conductive paste.

13. A method for controlling cooling, comprising:

starting a cooling process by controlling an air pump by a control unit so as to inject cooling air to a multi-stage heat sink through an air injection part;

determining, by the control unit, whether temperature of the multi-stage heat sink or the cooling air is higher than set cooling reference temperature;

correcting, by the control unit, cooling conditions if it is determined that the temperature of the multi-stage heat sink or the cooling air is higher than the set cooling reference temperature; and

performing, by the control unit, cooling using the multi-stage heat sink and the cooling air according to the corrected cooling conditions.

14. The method as set forth in claim 13, wherein in the starting of the cooling process, the air injection part includes a plurality of injection holes along steps of the multi-stage heat sink and each of the injection holes is engaged with step surfaces of the multi-stage heat sink.

15. The method as set forth in claim 13, wherein in the starting of the cooling process, the control unit receives temperature information of the multi-stage heat sink detected by a temperature sensor mounted at one portion of the multi-stage heat sink in real time.

16. The method as set forth in claim 13, wherein in the correcting of the cooling conditions, the cooling conditions include airflow rate, initial temperature, and flow velocity of the cooling air.

# FIG.1

FIG.2A

100-2

FIG.2B

105

100-3

# FIG.3

# FIG.4

# FIG.5

START

START COOLING USING MULTI-STAGE HEAT SINK ~S510

IS HIGHER THAN
COOLING REFERENCE
TEMPERATURE? ~S520

NO

↓YES

CORRECT COOLING CONDITION USING MULTI-STAGE
HEAT SINK ~S530

PERFORM COOLING WITH CORRECTED COOLING
CONDITION ~S540

END

# FIG.6

# FIG. 7

## REFERENCES CITED IN THE DESCRIPTION

**Patent documents cited in the description**

- KR 1020120075121
- KR 20020048844